# EUROPÄISCHE PATENTSCHRIFT

(11) **EP 4 513 199 B1**
(45) Veröffentlichungstag und Bekanntmachung des Hinweises auf die Patenterteilung: **06.08.2025**
(21) Anmeldenummer: 23192659.3
(22) Anmeldetag: 22.08.2023
(51) Int. Cl.: G01P 3/66, H03K 17/95, G01P 3/54, G01P 15/16

(54) **NÄHERUNGSSCHALTER ZUR GESCHWINDIGKEITSMESSUNG EINES MESSOBJEKTS**
PROXIMITY SWITCH FOR MEASURING THE SPEED OF A MEASUREMENT OBJECT
COMMUTATEUR DE PROXIMITÉ POUR LA MESURE DE LA VITESSE D'UN OBJET À MESURER

(43) Veröffentlichungstag der Anmeldung: 26.02.2025
(73) Patentinhaber: Pepperl+Fuchs SE, 68307 Mannheim (DE)
(72) Erfinder: Delic, Edin, 68307 Mannheim (DE)
(74) Vertreter: Banse & Steglich Patentanwälte PartmbB

(56) Entgegenhaltungen:
- WO-A1-2022/089689
- DE-A1- 102017 128 471
- US-A1- 2003 141 862

## Beschreibung

### Technisches Gebiet

Die Erfindung betrifft Näherungsschalter, die einen Schwingkreis aufweisen, der durch die Annäherung eines Messobjekts induktiv oder kapazitiv belastet wird. Weiterhin betrifft die vorliegende Erfindung eine Möglichkeit, eine Geschwindigkeit eines Messobjekts bezüglich einer Richtung eines Abstands zu dem Näherungsschalter zu bestimmen.

### Technischer Hintergrund

Näherungsschalter werden in der Automatisierungstechnik zur Überwachung eines Fertigungsprozesses und zum Triggern von Prozessschritten verwendet. Dabei weisen Näherungsschalter in der Regel eine einzige Auslöseschwelle auf, die einer bestimmten Entfernung eines Messobjekts von dem Näherungsschalter entspricht. Erreicht das Messobjekt diesen Abstand oder unterschreitet diesen, so wird dadurch die Annäherung eines Messobjekts signalisiert.

So ist beispielsweise aus DE 10 2017 128 471 A1 ein induktiver Näherungsschalter mit einem Schwingkreis mit einer Schwingkreisspule, mit einem Oszillatorverstärker und mit einer Ausgangsstufe bekannt, die mit dem Schwingkreis und/oder dem Oszillatorverstärker zusammenwirkt, um ein Ausgangssignal abhängig von einer Beeinflussung, insbesondere einer Dämpfung, des Schwingkreises durch ein nachzuweisendes Target bereitzustellen. Eine Stromquelle ist vorgesehen, um den Schwingkreis mit einem zeitlich veränderlichen Teststrom zu beaufschlagen. Eine Messeinrichtung misst den Teststrom und die Schwingkreisimpedanz auf Grundlage eines von dem Teststrom bewirkten Spannungsabfalls. Eine Kompensationseinrichtung ist dazu eingerichtet, den Schwingkreis, den Oszillatorverstärker und/oder die Ausgangsstufe in Abhängigkeit eines gemessenen Werts der Schwingkreisimpedanz einzustellen, um Veränderungen des Schwingkreises auszugleichen. Zur Bestimmung eines Schaltsignals wird die Resonanzimpedanz bei Annäherung eines zu überwachenden Targets an den Näherungsschalter ausgewertet. Dabei wird ein Komparator mit einer Schaltschwelle vorgesehen, um eine von der Resonanzimpedanz abhängige Spannung auszuwerten.

Für die meisten Anwendungen ist die Schaltfunktion des Näherungsschalters ausreichend, jedoch können Fälle auftreten, bei denen die Kenntnis der Geschwindigkeit der Annäherung des Messobjekts benötigt wird. Die Geschwindigkeitsinformation kann beispielsweise genutzt werden, um eine bessere Justage der Anwendung durchzuführen oder auch "Predictive Maintenance" einzuführen. Wird bisher eine Geschwindigkeitsinformation benötigt, so wird diese mithilfe eines separaten Sensorsystems erfasst, das häufig basierend auf einer Lichtschrankeneinheit ausgebildet ist.

Die Druckschrift WO 2022/089689 A1 offenbart einen Näherungsschalter mit einem ersten Sensorelement mit einem ersten Erfassungsbereich zur Erfassung eines sich durch den ersten Erfassungsbereich bewegenden Objektes, einem zweiten Sensorelement mit einem zweiten Erfassungsbereich zur Erfassung eines sich durch den zweiten Erfassungsbereich bewegenden Objektes und einem dritten Sensorelement mit einem dritten Erfassungsbereich zur Erfassung eines sich durch den dritten Erfassungsbereich bewegenden Objektes, wobei die Erfassungsbereiche der drei Sensorelemente räumlich derart verteilt angeordnet sind, dass ein sich in einer bestimmter Richtung durch die Erfassungsbereiche bewegendes Objekt nacheinander in die Erfassungsbereiche eintritt und diese in der gleichen Reihenfolge wieder verlässt, und wobei es einen Überlappungsbereich gibt, in dem sich die Erfassungsbereiche so überlappen, dass ein sich dort befindendes Objekt von allen drei Sensorelementen erfasst wird. Es ist eine Auswertelogik mit einem Zustandsautomaten zur Erkennung der Bewegungsrichtung und zur Identifizierung eines defekten Sensorelementes vorgesehen.

Die Druckschrift US 2003/141862 A1 offenbart einen Näherungsdetektor für magnetische Gegenstände, umfassend einen Magnetfeldsensor zum Liefern eines Ausgangssignals, das proportional zu einem Magnetfeld ist, eine Erfassungsschaltung zum Erfassen von mindestens einem von einem Parameter der Umgebung, in der der magnetische Artikel angeordnet ist, einem Parameter der Umgebung, in der der Detektor für die Nähe eines magnetischen Artikels angeordnet ist, einem Parameter, der sich auf eine Beziehung zwischen dem Detektor für die Nähe eines magnetischen Artikels und dem magnetischen Artikel bezieht, und einem Parameter des magnetischen Artikels; und eine Ausgabesteuerungsschaltung. Die Ausgabesteuerungsschaltung empfängt ein oder mehrere Signale von der Erfassungsschaltung und stellt in Reaktion auf das eine oder die mehreren Signale eine Datenfolge gemäß einem vorbestimmten Protokoll bereit, in dem ein erstes logisches Datenbit mit einem ersten logischen Wert in der Datenfolge von einem einzelnen Impuls mit einer ersten Impulscharakteristik bereitgestellt wird und ein zweites logisches Datenbit mit einem zweiten logischen Wert in der Datenfolge von einem einzelnen Impuls mit einer zweiten Impulscharakteristik bereitgestellt wird, wobei die zweite Impulsbreite ein Vielfaches der ersten Impulsbreite ist.

Es ist Aufgabe der vorliegenden Erfindung, einen Näherungsschalter zur Verfügung zu stellen, der mit geringem Schaltungsaufwand und in besonders effizienter und genauer Weise die Geschwindigkeit eines sich im Erfassungsbereich in axialer Richtung bewegenden Messobjekts bestimmen kann.

### Offenbarung der Erfindung

Diese Aufgabe wird durch den Näherungsschalter gemäß Anspruch 1 gelöst.

Weitere Ausgestaltungen sind in den abhängigen Ansprüchen angegeben.

Gemäß einem ersten Aspekt ist ein Näherungsschalter zur Detektion eines Messobjekts in einem Erfassungsbereich und zum Bestimmen einer Geschwindigkeitsangabe des Messobjekts vorgesehen, umfassend:
- einen Schwingkreis mit mindestens einer Schwingkreisinduktivität und mindestens einer Schwingkreiskapazität, wobei die mindestens eine Schwingkreisinduktivität zum Wechselwirken mit einem Messobjekt ausgelegt sind, sodass sich die Resonanzimpedanz des Schwingkreises abhängig von einem Abstand des Messobjekts von dem Schwingkreis ändert;
- einen Oszillationsverstärker, der mit dem Schwingkreis einen Oszillator bildet;
- eine Oszillationsmesseinheit zum Bestimmen eines Oszillationsmaßes;
- eine Schaltsignaleinheit, die ausgebildet ist, um ein erstes Schaltsignal bei Unter- oder Überschreiten einer ersten Schaltschwelle und ein zweites Schaltsignal bei Unter- oder Überschreiten einer zweiten, von der ersten verschiedenen Schaltschwelle zu generieren;
- einen Zeitgeber, der ausgebildet ist, um durch das erste Schaltsignal gestartet zu werden und das zweite Schaltsignal gestoppt zu werden und um eine Zeitangabe für die Zeitdauer zwischen dem ersten und dem zweiten Schaltsignal bereitzustellen;
- eine Geschwindigkeitsberechnungseinheit, die ausgebildet ist, um abhängig von der Zeitangabe eine Geschwindigkeitsangabe bereitzustellen.

Der obige Näherungsschalter weist einen Schwingkreis auf, mit einer Schwingkreisinduktivität und mindestens einer Schwingkreiskapazität. Der Schwingkreis bildet mit einem Oszillationsverstärker einen Oszillator. Der Oszillationsverstärker erhält im Betrieb eine Oszillation des Schwingkreises aufrecht. Amplitude und Frequenz der Oszillation hängen dabei von der Resonanzimpedanz ab, die durch die Impedanzen der Induktivität und der Kapazität der Schwingkreiskomponenten bestimmt ist.

Bei einem induktiven Näherungsschalter führt eine Annäherung eines elektrisch leitfähigen Messobjekts an eine Schwingkreisinduktivität zur Verstimmung des Schwingkreises und ändert somit dessen Resonanzimpedanz und das Oszillationsverhalten des Oszillators.

Durch entsprechende Auswertung eines Oszillationsmaßes kann ein zum Abstand zwischen der Schwingkreisinduktivität und dem Messobjekt abhängiges Spannungssignal erfasst werden.

Je nach Auslegung des Schwingkreises kann die Mittelspannung der Oszillation des Schwingkreises, eine Amplitude der Schwingung und die Oszillationsfrequenz charakteristisch für die effektive Resonanzimpedanz des Schwingkreises sein. Das Oszillationsmaß kann entsprechend durch eine Messspannung angegeben werden oder davon abgeleitet werden, die man beispielsweise durch Tiefpassfilterung einer Mittenspannung der Oszillation des Schwingkreises, einer Spitzenspannung der Oszillation des Schwingkreises oder durch Frequenz-Spannungs-Umsetzung erhält.

Es kann vorgesehen sein, dass die Schaltsignaleinheit ausgebildet ist, um die Messspannung mithilfe von zwei Komparatoren mit einer ersten Spannungsschwelle als erste Schaltschwelle bzw. mit einer zweiten Spannungsschwelle als zweite Schaltschwelle zu vergleichen, um das jeweilige erste bzw. zweite Schaltsignal zu generieren.

Anstelle des bisher üblichen einfachen Schwellwertvergleichs der Messspannung mit einer vorgegebenen Spannungsschwelle, um ein Schaltsignal des Näherungsschalters bereitzustellen, wird erfindungsgemäß die Messspannung nun mithilfe von zwei Schwellwertvergleichen mit unterschiedlichen Schaltschwellen ausgewertet. Die Schaltschwellen entsprechen unterschiedlichen Spannungsniveaus, die bestimmten Abständen des Messobjekts von der Schwingkreisinduktivität (bei induktivem Näherungsschalter) festgelegt sind.

Insbesondere ist der Differenzabstand zwischen den durch die Schaltschwellen vorgegebenen Abständen bekannt. Nähert sich ein Messobjekt in axialer Richtung dem Näherungsschalter, insbesondere direkt auf den Näherungsschalter zu, so werden aufgrund der unterschiedlichen Schaltschwellen zwei Schaltsignale generiert. Ein erstes Schaltsignal bei Durchlaufen einer ersten Schaltschwelle startet dabei einen digitalen Zeitgeber, und das zweite Schaltsignal bei Durchlaufen der zweiten Spannungsschwelle stoppt den Zeitgeber, um so eine Zeitangabe für die Zeitdauer zwischen den beiden Schaltsignalen zu erfassen. Der Zeitgeber kann als Zähler ausgebildet sein. Der Quotient aus dem vorbestimmten Differenzabstand zu der gemessenen Zeitangabe entspricht dabei einer Geschwindigkeitsangabe.

Weiterhin kann die Schaltsignaleinheit ausgebildet sein, um ein drittes Schaltsignal bei Unter- oder Überschreiten einer dritten Schaltschwelle zu generieren, wobei die dritte Schaltschwelle so gewählt ist, dass die zweite Schaltschwelle einen Abstand des Messobjekts angibt, der zwischen einem Abstand des Messobjekts bezüglich der ersten Schaltschwelle und einem Abstand des Messobjekts bezüglich der dritten Schaltschwelle liegt, wobei der Zeitgeber ausgebildet ist, um zusätzlich eine weitere Zeitangabe für die Zeitdauer zwischen dem zweiten und dem dritten Schaltsignal bereitzustellen, wobei die Geschwindigkeitsberechnungseinheit ausgebildet ist, um neben der Geschwindigkeitsangabe eine weitere Geschwindigkeitsangabe bezüglich der weiteren Zeitdauer bereitzustellen und abhängig von einem Unterschied der Geschwindigkeitsangaben eine Beschleunigungsangabe bereitzustellen.

Somit kann die dritte Schaltschwelle bei einem weiteren Abstand vorgesehen sein, um die Zeitangaben zum Durchlaufen der zwei Differenzabstände zu bestimmen. Durch die somit erhaltenen zwei Geschwindigkeitsangaben kann eine Beschleunigungsangabe des Messobjekts erfasst werden.

Gemäß einer weiteren Ausführungsform kann die Schaltsignaleinheit mit einem spannungsgesteuerten Oszillator ausgebildet sein, so dass mithilfe eines Zählers kontinuierlich ein Zählerwert abhängig von einer Periodendauer der Oszillation des spannungsgesteuerten Oszillators bereitgestellt wird, wobei die erste und die zweite Schaltschwelle als erste bzw. zweite Zählerwertschwelle bereitgestellt werden.

Gemäß einem weiteren Aspekt ist ein Verfahren zum Betreiben eines Näherungsschalters zur Detektion eines Messobjekts in einem Erfassungsbereich und zum Bestimmen einer Geschwindigkeitsangabe des Messobjekts vorgesehen, mit den folgenden Schritten:
- Betreiben eines Oszillators mit einem Oszillationsverstärker und einem Schwingkreis mit mindestens einer Schwingkreisinduktivität und mindestens einer Schwingkreiskapazität, wobei die mindestens eine Schwingkreisinduktivität zum Wechselwirken mit einem Messobjekt ausgelegt sind, sodass sich die Resonanzimpedanz des Schwingkreises abhängig von einem Abstand des Messobjekts on dem Schwingkreis ändert;
- Bestimmen eines Oszillationsmaßes;
- Generieren eines ersten Schaltsignals bei Unter- oder Überschreiten einer ersten Schaltschwelle und eines zweiten Schaltsignals bei Unter- oder Überschreiten einer zweiten, von der ersten verschiedenen Schaltschwelle;
- Messen einer Zeitangabe für die Zeitdauer zwischen dem ersten und dem zweiten Schaltsignal;
- Bereitstellen einer Geschwindigkeitsangabe abhängig von der Zeitangabe.

### Kurzbeschreibung der Zeichnungen

Ausführungsformen werden nachfolgend anhand der beigefügten Zeichnungen näher erläutert. Es zeigen:
- Figur 1: ein Schaltbild für einen induktiven Näherungsschalter mit einer Geschwindigkeitsbestimmung;
- Figur 2: ein Schaltbild für eine digitale Auswertung der Messspannung; und
- Figur 3: Signalverläufe am Kondensator zur Auswertung zum Ermitteln der Zeitangabe.

### Beschreibung von Ausführungsformen

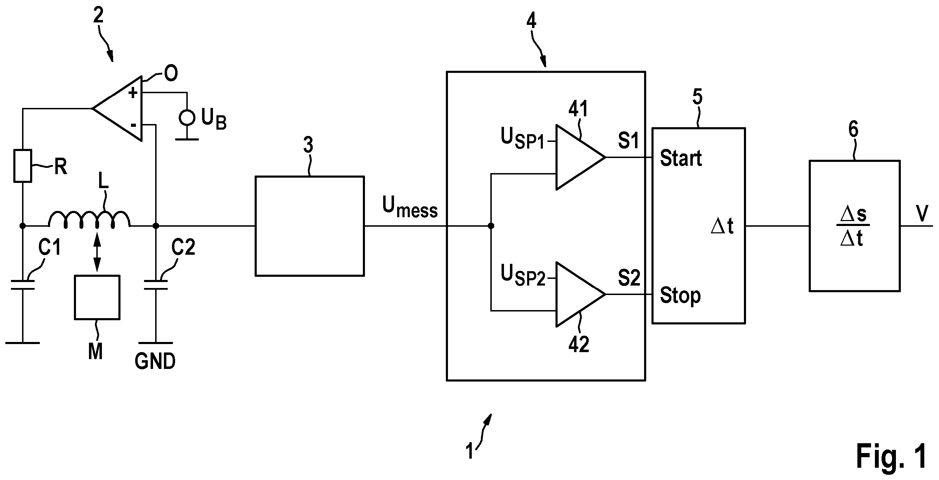

Figur 1 zeigt ein Schaltbild eines induktiven Näherungsschalters 1 mit einem LC-Schwingkreis 2, einer Oszillationsmesseinheit 3, einer Schaltsignaleinheit 4, einem Zeitgeber 5 und einer Geschwindigkeitsberechnungseinheit 6.

Der LC-Schwingkreis weist elektrische Schwingkreiskomponenten, eine Schwingkreis-Induktivität L und zwei Schwingkreiskapazitäten C1, C2 auf. Die Kapazitäten C1, C2 sind mit ihren ersten Anschlüssen mit einem Bezugspotenzial GND verbunden und zwischen ihren zweiten Anschlüssen ist die Schwingkreisinduktivität L geschaltet. Ein erster Anschluss der Schwingkreisinduktivität L ist mit einem invertierenden Eingang eines Operationsverstärkers O verbunden. Der Ausgang des Operationsverstärkers O ist über einen Widerstand R mit einem zweiten Anschluss der Schwingkreisinduktivität L verbunden. Der nichtinvertierende Eingang des Operationsverstärkers O ist mit einer Konstantspannungsquelle U_{B} verbunden.

Der Schwingkreis ist somit in bekannter Weise mit einem Operationsverstärker O als Oszillationsverstärker gekoppelt, um einen Oszillator zu bilden. Der Operationsverstärker O erfasst eine Spannung an dem ersten Anschluss der Schwingkreisinduktivität L, verstärkt diese und koppelt die verstärkte Spannung auf einen zweiten Anschluss der Schwingkreisinduktivität L. Diese Rückkopplung gleicht Energieverluste in dem LC-Schwingkreis aus und führt bei einer konstanten Resonanzimpedanz zu einer konstanten Oszillation des Schwingkreises 2. Die Frequenz und Amplitude der Oszillation hängt von den Impedanzen der Schwingkreiskomponenten ab.

Ist der Schwingkreis 2 für einen induktiven Näherungsschalter ausgelegt, so ist die effektive Impedanz der Schwingkreisinduktivität von dem Vorhandensein eines leitfähigen Messobjekts M in dem Erfassungsbereich des Schwingkreises 2 abhängig. Frequenz und Amplitude der Oszillation des Schwingkreises hängen somit von dem Abstand des Messobjekts M in dem Erfassungsbereich des Schwingkreises 2 ab.

Der erste Anschluss der Schwingkreisinduktivität L kann mit der Oszillationsmesseinheit 3 verbunden sein. Die Oszillationsmesseinheit 3 dient dazu, eine Messspannung Uₘₑₛₛ bereitzustellen, die die Oszillation des Schwingkreises 2 charakterisiert. Da abhängig von der Resonanzinduktivität die Frequenz und die Amplitude sowie die Mittelspannung, variieren, können diese zur Auswertung des Vorhandenseins eines Messobjekts verwendet werden. Insbesondere ist die Messspannung als Oszillationsmaß repräsentativ für den Abstand des Messobjekts M von der Schwingkreisinduktivität L.

So kann die Messspannung einem Oszillationsspitzenwert entsprechen, den man mit einem Spitzenwert-Gleichrichter erhält. Der Spitzenwert-Gleichrichter bestimmt den Maximalwert der Oszillation des Schwingkreises und kann durch eine einfache Gleichrichterschaltung mit einer nachgeschalteten Kapazität erhalten werden. Der Oszillationsspitzenwert hängt von dem Abstand eines Messobjekts im Erfassungsbereich des Schwingkreises ab. Zu einem Messobjekt mit einem bestimmten Abstand von der Schwingkreisinduktivität L ergibt sich somit eine konstante Messspannung am Ausgang des Spitzenwert-Gleichrichters.

In einer alternativen Ausführungsform kann die Oszillationsmesseinheit 3 auch in Form eines Tiefpassfilters ausgebildet sein, der die Mittelspannung der Oszillation als Messspannung bereitstellt und dazu den Schwingungsanteil der Oszillation herausfiltert.

Weiterhin kann die Oszillationsmesseinheit 3 auch als Frequenz-Spannungs-Umsetzer ausgebildet sein, der die Frequenz der Oszillationen in eine entsprechende Messspannung Uₘₑₛₛ wandelt.

Die Messspannung wird nun der Schaltsignaleinheit 4 zugeführt. Die Schaltsignaleinheit 4 kann bei analoger Ausführung zwei Komparatoren 41, 42 aufweisen, an die unterschiedliche Spannungsschwellen USP1 bzw. USP2 als Vergleichsspannungen angelegt sind. Bei Erreichen der jeweiligen Schaltschwelle wird ein erstes bzw. zweites Schaltsignal S1, S2 generiert, das zum Starten bzw. Stoppen eines Zeitgebers 5 dient. Der Zeitgeber 5 wird dabei von dem ersten Schaltsignal S1, d. h. bei Durchschreiten der ersten Spannungsschwelle USP1, gestartet, und beim zweiten Schaltsignal S2, d. h. beim Durchschreiten der zweiten Spannungsschwelle USP2, angehalten.

Die Spannungsschwellen USP1, USP2 sind entsprechend bekannten Abständen eines Messobjekts M von der Schwingkreisinduktivität definiert, zumindest ist ein Differenzabstand zwischen den Abständen, die durch die erste und die zweite Spannungsschwelle USP1, USP2 definiert sind, bestimmt.

Der Zeitgeber 5 kann einen Zähler aufweisen, der entsprechend nach dem ersten Schaltsignal und vor dem zweiten Schaltsignal mit einem vorgegebenen Taktsignal inkrementiert wird. Die Zeitangabe kann dem Zählerwert entsprechen.

Nach dem Stoppen des Zeitgebers 5 wird die Zeitangabe der Geschwindigkeitsberechnungseinheit 6 zugeführt, die eine Geschwindigkeitsangabe v abhängig von einem Quotienten zwischen dem vorbekannten Differenzabstand und der Zeitangabe bestimmt. Gleichzeitig kann das zweite Schaltsignal S2 verwendet werden, um das Vorhandensein des Messobjekts M anzuzeigen. Somit steht sowohl die Angabe über das Vorhandensein des Messobjekts M als auch deren Geschwindigkeitsangabe v über deren Geschwindigkeit zur Verfügung.

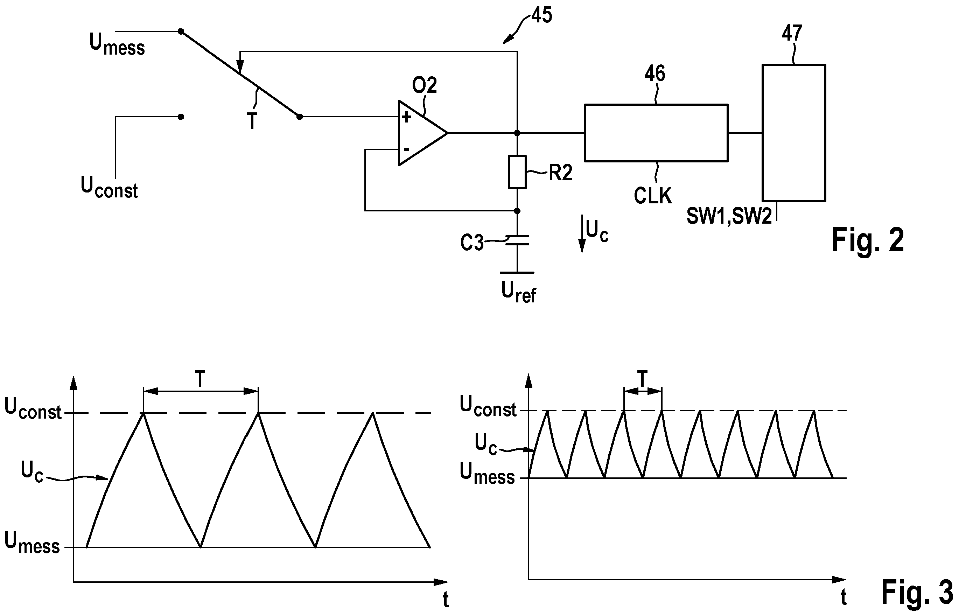

Im obigen Ausführungsbeispiel ist die Schaltsignaleinheit 4 analog ausgeführt, um in einem Schwellenwertvergleich die Messspannung mit den Spannungsschwellen USP1, USP2 zu vergleichen und das entsprechende Schaltsignal S1, S2 zu generieren. In einer alternativen Ausführungsform kann die Schaltsignaleinheit auch digital ausgebildet sein, wie beispielsweise in Figur 2 dargestellt ist. Dazu wird die Messspannung an eine Zählerschaltung 45 angelegt, die einen Operationsverstärker O2 aufweist. Der Ausgang des Operationsverstärkers O2 ist über einen Widerstand R2 mit einem invertierenden Eingang des Operationsverstärkers O2 rückgekoppelt. Weiterhin ist der invertierende Eingang des Operationsverstärkers O2 über einen Kondensator C3 mit einem Referenzpotenzial U_{ref} verbunden. Der nicht-invertierende Eingang des Operationsverstärkers O2 ist über einen Halbleiterschalter T mit der Messspannung Uₘₑₛₛ und einer Konstantspannung U_{const} verbunden. Der Halbleiterschalter T wird von dem Signal am Ausgang des Operationsverstärkers O2 gesteuert. Die Konstantspannung U_{const} ist so gewählt, dass diese höher ist als die Spannungen Uₘₑₛₛ. Die Zählerschaltung 45 ist so ausgelegt, dass bei Erreichen der Konstantspannung U_{const} am Ausgang des Operationsverstärkers O2 diese den Halbleiterschalter T so schaltet, dass die Messspannung Uₘₑₛₛ an den nicht-invertierenden Eingang des Operationsverstärker O2 angelegt wird und dass bei Erreichen des Potenzials der Messspannung Uₘₑₛₛ am Ausgang des Operationsverstärkers O2 der Halbleiterschalter T so geschaltet wird, dass die Konstantspannung U_{const} an den nicht-invertierenden Eingang des Operationsverstärkers O2 angelegt wird.

Figur 3 zeigt für zwei verschiedene Messspannungen die resultierenden Oszillationen am Ausgang des Operationsverstärkers O2. Der Ausgang des Operationsverstärkers O2 ist weiterhin mit einem Zähler 46 verbunden, der einen Systemtakt CLK zählt und eine Zeitmessung der Periodendauer, d.h. der Zeitdauer zwischen den Spitzenwerten der Oszillationen am Ausgang des Operationsverstärkers O2 vornimmt. Der Systemtakt CLK kann im Bereich zwischen 10 und 200 MHz gewählt sein und ermöglicht es somit, bei Oszillationsfrequenzen am Ausgang des Operationsverstärkers O2 von zwischen 1 und 50 kHz sehr genaue Messungen der Periodendauer vorzunehmen.

Nach jedem Messen der Periodendauer wird der Zählerwert des Zählers 46 in einer Auswertungseinheit 47 ausgewertet und mit zwei Schwellenwerten SW1, SW2 verglichen, die jeweils einem bestimmten Abstand des Messobjekts vom Schwingkreis entsprechen. In der Auswertungseinheit 47 wird bei Unter- oder Überschreiten des ersten Schwellenwerts SW 1 ein weiterer Zähler gestartet und bei Unter- oder Überschreiten des zweiten Zählerwerts der weitere Zähler wieder gestoppt, so dass der Zählerwert des weiteren Zählers als die entsprechende Zeitangabe zur weiteren Auswertung in der Geschwindigkeitsberechnungseinheit 6 zur Verfügung gestellt werden kann.

## Patentansprüche

1. Näherungsschalter (1) zur Detektion eines Messobjekts (M) in einem Erfassungsbereich und zum Bestimmen einer Geschwindigkeitsangabe des Messobjekts (M), umfassend:
- einen Schwingkreis (2) mit mindestens einer Schwingkreisinduktivität (L) und mindestens einer Schwingkreiskapazität (C1, C2), wobei die mindestens eine Schwingkreisinduktivität (L) zum Wechselwirken mit einem Messobjekt ausgelegt sind, sodass sich die Resonanzimpedanz des Schwingkreises (2) abhängig von einem Abstand des Messobjekts (M) von dem Schwingkreis (2) ändert;
- einen Oszillationsverstärker (O), der mit dem Schwingkreis einen Oszillator bildet;
- eine Oszillationsmesseinheit (3) zum Bestimmen eines Oszillationsmaßes;
- eine Schaltsignaleinheit (4), die ausgebildet ist, um ein erstes Schaltsignal (S1) bei Unter- oder Überschreiten einer ersten Schaltschwelle (USP1, SW1) und ein zweites Schaltsignal (S2) bei Unter- oder Überschreiten einer zweiten, von der ersten verschiedenen Schaltschwelle (USP2, SW2) zu generieren, wobei die Schaltschwellen (USP1, SW1, USP2, SW2) unterschiedlichen Spannungsniveaus entsprechen, die als bestimmte Abstände des Messobjekts (M) von der Schwingkreisinduktivität (L) festgelegt sind, wobei der Differenzabstand zwischen den durch die Schaltschwellen (USP1, SW1, USP2, SW2) bestimmten Abständen bekannt ist;
- einen Zeitgeber (5), der ausgebildet ist, um durch das erste Schaltsignal (S1) gestartet zu werden und das zweite Schaltsignal (S2) gestoppt zu werden und um eine Zeitangabe für die Zeitdauer zwischen dem ersten und dem zweiten Schaltsignal (S1, S2) bereitzustellen;
- eine Geschwindigkeitsberechnungseinheit (6), die ausgebildet ist, um abhängig von der Zeitangabe eine Geschwindigkeitsangabe bereitzustellen, wobei der Quotient aus dem Differenzabstand zu der gemessenen Zeitangabe der Geschwindigkeitsangabe entspricht.

2. Näherungsschalter (1) nach Anspruch 1, wobei die Oszillationsmesseinheit (3)
- einen Tiefpassfilter aufweist, um eine Mittelspannung der Oszillation des Schwingkreises als Oszillationsmaß bereitzustellen,
- einen Gleichrichter aufweist, um eine Spitzenspannung der Oszillation des Schwingkreises als Oszillationsmaß bereitzustellen, oder
- einen Frequenz-Spannungs-Umsetzer aufweist, um eine frequenzabhängige Spannung als Oszillationsmaß bereitzustellen.

3. Näherungsschalter (1) nach Anspruch 1 oder 2, wobei die Schaltsignaleinheit (4) ausgebildet ist, um die Messspannung mithilfe von zwei Komparatoren (41, 42) mit einer ersten Spannungsschwelle (USP1) als erste Schaltschwelle bzw. mit einer zweiten Spannungsschwelle (USP2) als zweite Schaltschwelle zu vergleichen, um das jeweilige erste bzw. zweite Schaltsignal (S1, S2) zu generieren.

4. Näherungsschalter (1) nach einem der Ansprüche 1 bis 3, wobei die Schaltsignaleinheit (4) ausgebildet ist, um ein drittes Schaltsignal bei Unter- oder Überschreiten einer dritten Schaltschwelle zu generieren, wobei die dritte Schaltschwelle so gewählt ist, dass die zweite Schaltschwelle einen Abstand des Messobjekts angibt, der zwischen einem Abstand des Messobjekts (M) bezüglich der ersten Schaltschwelle und einem Abstand des Messobjekts (M) bezüglich der dritten Schaltschwelle liegt, wobei der Zeitgeber ausgebildet ist, um zusätzlich eine weitere Zeitangabe für die Zeitdauer zwischen dem zweiten und dem dritten Schaltsignal bereitzustellen, wobei die Geschwindigkeitsberechnungseinheit ausgebildet ist, um neben der Geschwindigkeitsangabe eine weitere Geschwindigkeitsangabe bezüglich der weiteren Zeitdauer bereitzustellen und abhängig von einem Unterschied der Geschwindigkeitsangaben eine Beschleunigungsangabe bereitzustellen.

5. Näherungsschalter (1) nach einem der Ansprüche 1 bis 4, wobei die Schaltsignaleinheit (4) mit einem spannungsgesteuerten Oszillator ausgebildet ist, so dass mithilfe eines Zählers (46) kontinuierlich ein Zählerwert abhängig von einer Periodendauer der Oszillation des spannungsgesteuerten Oszillators bereitgestellt wird, wobei die erste und die zweite Schaltschwelle als erste bzw. zweite Zählerwertschwelle (SW1, SW2) bereitgestellt werden.

6. Näherungsschalter (1) nach einem der Ansprüche 1 bis 5, wobei die Geschwindigkeitsberechnungseinheit (6) ausgebildet ist, um die Geschwindigkeitsangabe zu signalisieren.

7. Verfahren zum Betreiben eines Näherungsschalters (1) zur Detektion eines Messobjekts (M) in einem Erfassungsbereich und zum Bestimmen einer Geschwindigkeitsangabe des Messobjekts (M), mit den folgenden Schritten:
- Betreiben eines Oszillators mit einem Oszillationsverstärker (O) und einem Schwingkreis (2) mit mindestens einer Schwingkreisinduktivität (L) und mindestens einer Schwingkreiskapazität (C1, C2), wobei die mindestens eine Schwingkreisinduktivität (L) zum Wechselwirken mit einem Messobjekt ausgelegt sind, sodass sich die Resonanzimpedanz des Schwingkreises (2) abhängig von einem Abstand des Messobjekts (M) von dem Schwingkreis (2) ändert;
- Bestimmen eines Oszillationsmaßes;
- Generieren eines ersten Schaltsignals (S1) bei Unter- oder Überschreiten einer ersten Schaltschwelle (USP1, SW1) und eines zweiten Schaltsignals (S2) bei Unter- oder Überschreiten einer zweiten, von der ersten verschiedenen Schaltschwelle (USP2, SW2), wobei die Schaltschwellen (USP1, SW1, USP2, SW2) unterschiedlichen Spannungsniveaus entsprechen, die als bestimmte Abstände des Messobjekts (M) von der Schwingkreisinduktivität (L) festgelegt sind, wobei der Differenzabstand zwischen den durch die Schaltschwellen (USP1, SW1, USP2, SW2) bestimmten Abständen bekannt ist;
- Messen einer Zeitangabe für die Zeitdauer zwischen dem ersten und dem zweiten Schaltsignal (S1, S2); und
- Bereitstellen einer Geschwindigkeitsangabe abhängig von der Zeitangabe, wobei der Quotient aus dem Differenzabstand zu der gemessenen Zeitangabe der Geschwindigkeitsangabe entspricht.

## Claims

1. Proximity switch (1) for detecting a measuring object (M) in a detection range and for determining a speed value of the measuring object (M), comprising:
- an oscillating circuit (2) with at least one resonant circuit inductance (L) and at least one resonant circuit capacitance (C1, C2), wherein the at least one resonant circuit inductance (L) is designed to interact with a measuring object such that the resonance impedance of the oscillating circuit (2) changes as a function of a distance of the measuring object (M) from the oscillating circuit (2);
- an oscillation amplifier (O) which forms an oscillator with the oscillating circuit;
- an oscillation measuring unit (3) for determining an oscillation measure;
- a switching signal unit (4) configured to generate a first switching signal (S1) when a first switching threshold (USP1, SW1) is exceeded or undercut, and a second switching signal (S2) when a second switching threshold (USP2) different from the first switching threshold is exceeded or undercut (USP2, SW2), wherein the switching thresholds (USP1, SW1, USP2, SW2) correspond to different voltage levels which are defined as specific distances of the measuring object (M) from the resonant circuit inductance (L), wherein the difference between the distances determined by the switching thresholds (USP1, SW1, USP2, SW2) is known;
- a timer (5) designed to be started by the first switching signal (S1) and stopped by the second switching signal (S2) and to provide a time indication for the time interval between the first and second switching signals (S1, S2);
- a speed calculation unit (6) designed to provide a speed indication depending on the time indication, wherein the quotient of the difference between the measured time indication and the speed indication corresponds to the speed.

2. Proximity switch (1) according to claim 1, wherein the oscillation measuring unit (3)
- has a low-pass filter for providing a mean voltage of the oscillation of the oscillating circuit as an oscillation measure,
- has a rectifier for providing a peak voltage of the oscillation of the oscillating circuit as an oscillation measure, or
- a frequency-voltage converter for providing a frequency-dependent voltage as an oscillation measure.

3. Proximity switch (1) according to claim 1 or 2, wherein the switching signal unit (4) is configured to compare the measured voltage with two comparators (41, 42) with a first voltage threshold (USP1) as a first switching threshold and with a second voltage threshold (USP2) as a second switching threshold in order to generate the respective first and second switching signals (S1, S2).

4. Proximity switch (1) according to any of claims 1 to 3, wherein the switching signal unit (4) is configured to generate a third switching signal when a third switching threshold is exceeded or undercut, wherein the third switching threshold is selected such that the second switching threshold indicates a distance of the measuring object which lies between a distance of the measuring object (M) relative to the first switching threshold and a distance of the measuring object (M) relative to the third switching threshold, wherein the timer is designed to additionally provide a further time indication for the time duration between the second and third switching signals, wherein the speed calculation unit is configured to provide, in addition to the speed indication, a further speed indication relating to the further time duration and to provide an acceleration indication depending on a difference between the speed indications.

5. Proximity switch (1) according to one of claims 1 to 4, wherein the switching signal unit (4) is designed with a voltage-controlled oscillator so that a counter value is continuously provided by means of a counter (46) depending on a period duration of the oscillation of the voltage-controlled oscillator, wherein the first and second switching thresholds are provided as first and second counter value thresholds (SW1, SW2).

6. Proximity switch (1) according to one of claims 1 to 5, wherein the speed calculation unit (6) is designed to signal the speed indication.

7. Method for operating a proximity switch (1) for detecting a measuring object (M) in a detection range and for determining a speed indication of the measuring object (M), comprising the following steps:
- Operating an oscillator with an oscillation amplifier (O) and an oscillating circuit (2) with at least one resonant circuit inductance (L) and at least one resonant circuit capacitance (C1, C2), wherein the at least one resonant circuit inductance (L) is designed to interact with a measuring object so that the resonance impedance of the oscillating circuit (2) changes as a function of a distance of the measuring object (M) from the oscillating circuit (2);
- determining an oscillation measure;
- generating a first switching signal (S1) when a first switching threshold (USP1, SW1) is exceeded or undercut, and a second switching signal (S2) when a second switching threshold (USP2, SW2) different from the first switching threshold is exceeded or undercut, wherein the switching thresholds (USP1, SW1, USP2, SW2) correspond to different voltage levels which are defined as specific distances of the measuring object (M) from the resonant circuit inductance (L), wherein the difference between the distances determined by the switching thresholds (USP1, SW1, USP2, SW2) is known;
- measuring a time value for the time duration between the first and second switching signals (S1, S2); and
- providing a speed value dependent on the time value, wherein the quotient of the difference between the measured time value and the measured time value corresponds to the speed value.

## Revendications

1. Détecteur de proximité (1) pour détecter un objet à mesurer (M) dans une zone de détection et pour déterminer une indication de vitesse de l'objet à mesurer (M), comprenant :
- un circuit oscillant (2) avec au moins une inductance de circuit oscillant (L) et au moins une capacité de circuit oscillant (C1, C2), la au moins une inductance de circuit oscillant (L) étant conçue pour interagir avec un objet à mesurer de telle sorte que l'impédance de résonance du circuit oscillant (2) varie en fonction d'une distance entre l'objet à mesurer (M) et le circuit oscillant (2) ;
- un amplificateur d'oscillation (O) qui forme un oscillateur avec le circuit oscillant ;
- une unité de mesure d'oscillation (3) pour déterminer une mesure d'oscillation;
- une unité de signal de commutation (4) configurée pour générer un premier signal de commutation (S1) en cas de dépassement vers le bas ou vers le haut d'un premier seuil de commutation (USP1, SW1) et un deuxième signal de commutation (S2) en cas de dépassement vers le bas ou vers le haut d'un deuxième seuil de commutation différent du premier (USP2, SW2) lorsque la première valeur de consigne (V1) est dépassée ou n'est pas atteinte, les seuils de commutation (USP1, SW1, USP2, SW2) correspondant à différents niveaux de tension qui sont définis comme des distances déterminées de l'objet à mesurer (M) par rapport à l'inductance du circuit oscillant (L), la différence de distance entre les distances déterminées par les seuils de commutation (USP1, SW1, USP2, SW2) ;
- une minuterie (5) configurée pour être démarrée par le premier signal de commutation (S1) et arrêtée par le deuxième signal de commutation (S2) et pour fournir une indication temporelle de la durée entre le premier et le deuxième signal de commutation (S1, S2) ;
- une unité de calcul de vitesse (6) configurée pour fournir une indication de vitesse en fonction de l'indication de temps, le quotient de la différence de distance par rapport à l'indication de temps mesurée correspondant à l'indication de vitesse.

2. Détecteur de proximité (1) selon la revendication 1, dans lequel l'unité de mesure d'oscillation (3)
- comporte un filtre passe-bas pour fournir une tension moyenne de l'oscillation du circuit oscillant comme mesure d'oscillation,
- comporte un redresseur pour fournir une tension de crête de l'oscillation du circuit oscillant comme mesure d'oscillation, ou
- un convertisseur fréquence-tension pour fournir une tension dépendante de la fréquence comme mesure d'oscillation.

3. Détecteur de proximité (1) selon la revendication 1 ou 2, dans lequel l'unité de signal de commutation (4) est conçue pour comparer la tension de mesure à l'aide de deux comparateurs (41, 42) avec un premier seuil de tension (USP1) comme premier seuil de commutation et avec un deuxième seuil de tension (USP2) comme deuxième seuil de commutation afin de générer le premier ou le deuxième signal de commutation (S1, S2) respectif.

4. Détecteur de proximité (1) selon l'une des revendications 1 à 3, dans lequel l'unité de signal de commutation (4) est conçue pour générer un troisième signal de commutation en cas de dépassement vers le bas ou vers le haut d'un troisième seuil de commutation, le troisième seuil de commutation étant choisi de telle sorte que le deuxième seuil de commutation indique une distance de l'objet à mesurer qui se situe entre une distance de l'objet à mesurer (M) par rapport au premier seuil de commutation et une distance de l'objet à mesurer (M) par rapport au troisième seuil de commutation, le temporisateur étant conçu pour fournir en outre une autre indication de temps pour la durée entre le deuxième et le troisième signal de commutation, l'unité de calcul de vitesse étant conçue pour fournir, outre l'indication de vitesse, une autre indication de vitesse relative à la durée supplémentaire et pour fournir une indication d'accélaration en fonction d'une différence entre les indications de vitesse.

5. Détecteur de proximité (1) selon l'une des revendications 1 à 4, l'unité de signal de commutation (4) est configuré avec un oscillateur commandé par tension, de sorte qu'à l'aide d'un compteur (46), une valeur de comptage dépendant d'une durée de période de l'oscillation de l'oscillateur commandé par tension est fournie en continu, les premier et deuxième seuils de commutation étant fournis comme premier et deuxième seuils de valeur de comptage (SW1, SW2).

6. Détecteur de proximité (1) selon l'une des revendications 1 à 5, l'unité de calcul de vitesse (6) étant configuré pour signaler l'indication de vitesse.

7. Procédé pour faire fonctionner un détecteur de proximité (1) pour détecter un objet à mesurer (M) dans une zone de détection et pour déterminer une indication de vitesse de l'objet à mesurer (M), comprenant les étapes suivantes :
- actionnement d'un oscillateur avec un amplificateur d'oscillation (O) et un circuit oscillant (2) avec au moins une inductance de circuit oscillant (L) et au moins une capacité de circuit oscillant (C1, C2), la au moins une inductance de circuit oscillant (L) étant configurée pour interagir avec un objet à mesurer de telle sorte que l'impédance de résonance du circuit oscillant (2) varie en fonction d'une distance entre l'objet à mesurer (M) et le circuit oscillant (2) ;
- détermination d'un coefficient d'oscillation ;
- génération d'un premier signal de commutation (S1) lors du franchissement vers le bas ou vers le haut d'un premier seuil de commutation (USP1, SW1) et d'un deuxième signal de commutation (S2) lors du franchissement vers le bas ou vers le haut d'un deuxième seuil de commutation (USP2, SW2) différent du premier, les seuils de commutation (USP1, SW1, USP2, SW2) correspondent à différents niveaux de tension qui sont définis comme des distances déterminées entre l'objet à mesurer (M) et l'inductance du circuit oscillant (L), la différence entre les distances déterminées par les seuils de commutation (USP1, SW1, USP2, SW2) étant connue ;
- mesurer une indication de temps pour la durée entre le premier et le deuxième signal de commutation (S1, S2) ; et
- fournir une indication de vitesse en fonction de l'indication de temps, le quotient de la différence de distance par rapport à l'indication de temps mesurée correspondant à l'indication de vitesse.
